# EUROPEAN PATENT APPLICATION

(11) **EP 4 134 187 A1**
(43) Date of publication of application: **15.02.2023**
(21) Application number: 22797249.4
(22) Date of filing: 07.04.2022
(51) Int. Cl.: B22F 9/14, B22F 1/07, C22C 1/04, C22C 5/02, B22F 9/08

(54) **GOLD NANOPARTICLE PREPARATION METHOD**

(30) Priority: 03.05.2021 KR 20210057332
(71) Applicant: Jeunex Co., Ltd., Seoul 06016 (KR)
(72) Inventor: LEE, Ji Sang, Seongnam-si Gyeonggi-do 13523 (KR); KIM, Jung Bin, Seoul 06802 (KR); SUNG, Ki Su, Seongnam-si Gyeonggi-do 13603 (KR); JANG, Hye Jin, Seoul 04902 (KR); KIM, Sang Min, Dalseong-gun Daegu 42913 (KR)
(74) Representative: Danubia Patent & Law Office LLC
(86) International application number: PCT/KR2022/005039
(87) International publication number: WO 2022/234961

(57) **Abstract**

The present invention relates to a method for manufacturing gold nanoparticles, including: (a) placing a gold (Au) target on a magnet cathode and injecting argon (Ar) gas to generate plasma; (b) discharging powder of a compound having an non-shared electron pair upwardly in parallel to a vertical rotation axis inside a stirrer, followed by circulating and agitating the same up and down; and (c) ejecting the gold particles and binding the same to the compound having the non-shared electron pair, as well as gold nanoparticles manufactured by the same.

The present invention relates to a method for obtaining gold nanoparticles bound to niacinamide through vacuum deposition, which is generally used to form a thin film, wherein niacinamide is used by circulating and agitating the same up and down under special conditions, so as to produce high purity gold nanoparticles in high yield.

## Description

### Field of Invention

The present invention relates to a method for manufacturing gold nanoparticles, including: (a) placing a gold (Au) target on a magnet cathode and injecting argon (Ar) gas to generate plasma; (b) discharging powder of a compound having an non-shared electron pair upwardly in parallel to a vertical rotation axis inside a stirrer, followed by circulating and agitating the same up and down; and (c) ejecting the gold particles and binding the same to the compound having the non-shared electron pair, as well as gold nanoparticles manufactured by the same.

### Background of Invention

Nanoparticles exhibit unique properties different from the bulk state of a material used for the nanoparticles, and are attracting great attention due to various application possibilities thereof. Among them, metal nanoparticles are being applied in a variety of fields such as electronics, information storage and catalysts due to the interesting properties of metals, and recently, their application fields are being expanded to cosmetics and medical fields as well as optoelectronics, sensing, and imaging.

On the other hand, gold nanoparticles are widely applied in biomedical fields due to the advantages of being harmless to the human body and easy for surface modification through bonding with thiol. Gold nanoparticles are also being applied for therapeutic purposes beyond diagnosis, specifically, a therapeutic method of treating radiation-exposed tumors by selectively adhering gold nanoparticles to the tumors, a study for improving cell destruction efficiency in radiation therapy by adhering gold nanoparticles to the cell surface, a research for application of gold nanoparticles as a mediator for drug delivery, etc. have been reported. Further, gold nanoparticles are widely applied electrochemically because these have excellent electrical conductivity as well as superior bio-adhesiveness. For example, it has been applied to material detection through minute electrical signal changes on the surface of gold nanoparticles, or has been used as a material to enhance the sensitivity of an electro chemiluminescent (ECL) sensor. Further, although it is known that gold in the bulk state is chemically very stable and is inert, but gold nanoparticles exhibit strong catalytic activity and are applied as catalysts or electrochemical catalysts in different reactions including hydrogenation of olefins and CO oxidation.

Under such backgrounds as described above, as a result of earnest efforts to improve the productivity of gold nanoparticles utilized in various fields, the present invention was completed by confirming a manufacturing method capable of increasing the purity and yield of gold nanoparticles.

### Summary of Invention

### Technical Problem to be Solved

One object of the present invention is to provide a method for manufacturing gold nanoparticles, including: (a) placing a gold (Au) target on a magnet cathode and injecting argon (Ar) gas to generate plasma; (b) discharging powder of a compound having an non-shared electron pair upwardly in parallel to a vertical rotation axis inside a stirrer, followed by circulating and agitating the same up and down; and (c) ejecting the gold particles and binding the same to the compound having the non-shared electron pair, as well as gold nanoparticles manufactured by the same.

Another object of the present invention is to provide gold nanoparticles manufactured by the above method.

### Technical Solution

The above objects will be described in detail as follows. Meanwhile, the description and embodiment disclosed in the present invention may be applied to other descriptions and embodiments. That is, all combinations of diverse elements disclosed herein fall within the scope of the present invention. Further, it would not be considered that the scope of the present invention is limited by the specific descriptions described below.

One aspect of the present invention to achieve the above object, there is provided a method for manufacturing gold nanoparticles, which includes: (a) placing a gold (Au) target on a magnet cathode on a magnet cathode and injecting argon (Ar) gas to generate plasma; (b) discharging powder of a compound having an non-shared electron pair upwardly in parallel to a vertical rotation axis inside a stirrer, followed by circulating and agitating the same up and down; and (c) ejecting the gold particles and binding the same to the compound having the non-shared electron pair, as well as gold nanoparticles manufactured by the same.

The gold nanoparticles of the present invention have a gold particle size of nanometers, and are used diversely in the medical application, for example, as a drug carrier by adhering a drug such as an anticancer drug to the gold nanoparticles or by adhering a specific antibody thereto to detect an antigen on the cell surface, etc. Further, attempts to apply gold nanoparticles to the bio-field such as being contained in cosmetics or foods are further increasing. Further, due to catalytic activity thereof, it is also being applied in the field of electrochemistry. Therefore, for practical application of gold nanoparticles, a technology enabling mass-production of gold nanoparticles with desired quality is required.

The method for manufacturing gold nanoparticles of the present invention may utilize vacuum deposition, which is the conventional thin film manufacturing technique, so as to allow production of nanoparticles having the same purity as a target metal without moisture, harmful gas, foreign substances, and the like.

The "compound having a non-shared electron pair" of the present invention may be used as a carrier to which a target may be bound, and any compound having a non-shared electron pair remaining without participating in the reaction may be included therein without limitation thereof. Specifically, it may be a compound containing a thiol group or ketone group and, in the present invention, niacinamide was used as a representative example of the compound containing the thiol or ketone group.

In the present invention, the term "niacinamide" is a compound having a molecular formula C₆H₆N₂₀ and a molecular weight of 122.12 g/mol. As a kind of vitamin B complex, this compound coexists with nicotinic acid, is widely distributed in plants and exists as a component of the redox coenzyme NAD⁺ or NADP⁺ in the living body of animals. It is used as a raw material for cosmetics due to whitening effects thereof.

In the present invention, niacinamide may be used as a carrier to which the gold particles are bound, and the ejected gold particles may be bound to the surface of the niacinamide powder being stirred. In a specific embodiment of the present invention, a size and purity of gold nanoparticles when niacinamide, glucose and hydroxyl ethyl cellulose (HEC) are used as carriers, respectively, were subjected to comparative analysis. As a result, it was confirmed that, when niacinamide is used, the gold nanoparticles have the smallest size and the highest purity (Example 3).

The vacuum device used in the present invention may be provided with a stirrer and an evaporation source for generating vapor particles. Further, the vacuum device of the present invention may be connected to a mass flow controller (MFC) and a rotary pump, so as to supply a coolant to an outer wall of the stirrer to maintain a predetermined temperature while keeping a constant vacuum degree.

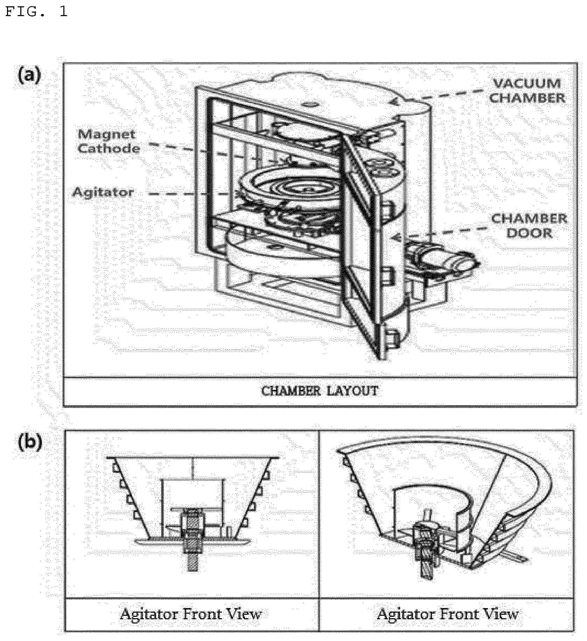

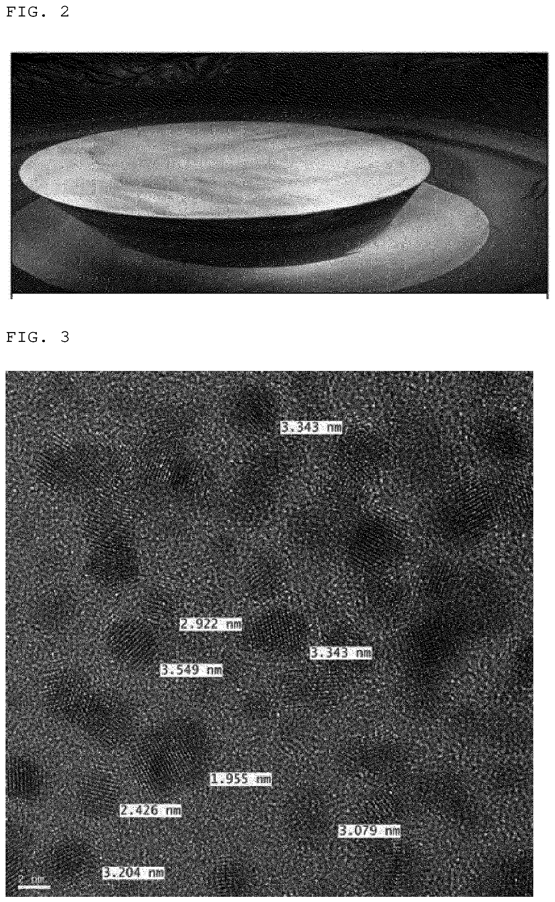

The stirrer is specifically fabricated to have an angle of stirrer blades of 45 to 80°, in order to prevent niacinamide agitated in the stirrer from sticking together or inhibit stagnant stirring, and may be formed in a screw type with application of a vertical rotation axis (FIG. 1b). Accordingly, niacinamide inside a cylinder surrounding the blades of the stirrer is discharged and scattered upwards in parallel to the vertical rotation axis inside the stirrer rather than in left and right sides (FIG. 2). Niacinamide in powder form is not stagnant or stopped, but continues to circulate up and down while freely falling and collides with the ejected gold (Au) atoms.

In a specific embodiment of the present invention, by forming a different structure of the stirrer and, as a result of comparing the yield of gold nanoparticles according to a stirring direction of the carrier, it could be seen that the yield of gold nanoparticles is significantly different depending on the stirring direction. Specifically, as a result of preparing gold nanoparticles using: a stirrer in which the carrier is discharged upwardly and circulates up and down in parallel to the vertical rotation axis (Experimental Example 1); a stirrer in which the carrier rotates about the vertical rotation axis (Comparative Example 1); and a stirrer in which the carrier rotates about a horizontal rotation axis (Comparative Example 2), etc., it was confirmed that the yield is the highest when using the stirrer of the present invention in which the carrier is discharged upward in parallel to the vertical rotation axis and circulated up and down (Example 2).

The method for manufacturing gold nanoparticles according to the present invention may specifically include preparing gold in a size capable of being bound to a magnet cathode, and disposing the same on the magnet cathode. Then, after a vacuum degree inside the chamber reaches 2.0 to 3.0 × 10⁻⁵ torr, argon gas as an inert gas is injected to generate plasma. At this time, the vacuum degree inside the chamber is rapidly changed to 1.0 to 2.0 x 10⁻² torr, and this vacuum degree of 1.0 to 2.0 x 10⁻² torr may be maintained along with a temperature of 60 to 70 °C by operating a mass flow controller (MFC) and a rotary pump. By generating plasma on the surface of the gold target in a vacuum, pure gold particles of several nanometers may be freely ejected. The ejected gold particles are induced to bind to the surface of niacinamide. At this time, in order to prevent the gold particles bound to niacinamide from being recombined between gold particles and increasing a size of the particles, the stirrer may be coupled in the vacuum chamber to make the niacinamide flow physically. The ejected gold particles may be either weakly bound to niacinamide or unbound and agitated along with niacinamide in the form of particles, and the same process may be repeated until the agitation is stopped and the vacuum is broken off. As a result, since niacinamide flowing up and down prevents recombination between the ejected gold particles, perfectly separated gold nanoparticles having a size of 1 to 5 nm can be obtained.

The method for manufacturing gold nanoparticles of the present invention may further include (d) heating niacinamide. Since the carrier, that is, niacinamide is dissolved by applying heat thereto, only pure gold nanoparticles bound to the niacinamide may be obtained.

Another aspect of the present invention is to provide gold nanoparticles manufactured according to the above method.

The gold nanoparticles of the present invention may be included in a medical or pharmaceutical composition, a cosmetic composition, and the like. The gold nanoparticles of the present invention have high purity and small particle size, and thus may have high utility in different industries.

### Effect of Invention

The present invention relates to a method for obtaining gold nanoparticles bound to niacinamide through vacuum deposition, which is generally used to form a thin film, wherein niacinamide is used by circulating and agitating the same up and down under special conditions, so as to produce high purity gold nanoparticles in high yield.

### Brief Description of Drawings

FIG. 1 illustrates a vacuum device used for preparing gold nanoparticles of the present invention, wherein FIG. 1a is a diagram showing a vacuum chamber, and FIG. 1b is a diagram showing front and side views of a stirrer disposed in the vacuum chamber.
FIG. 2 is a diagram illustrating the state of the stirrer charged with niacinamide.
FIG. 3 illustrates TEM image of the gold nanoparticles manufactured by the method of the present invention.

### Detailed Description of Preferred Embodiments of Invention

Hereinafter, the present invention will be described in more detail by means of examples. However, these examples are for illustrative purposes only and the scope of the present invention is not limited to these examples.

### Example 1. Preparation of Gold Nanoparticles

### Example 1-1. Vacuum chamber and stirrer

In Examples to be described later, niacinamide was used as a representative example of the compound containing a ketone group. A stirrer was placed in the vacuum chamber to allow the niacinamide to move fluidly (or flow) by applying physical force in a vacuum state (FIG. 1a). The stirrer was specifically fabricated to have an angle of stirrer blades between 45 and 80° in order to prevent the niacinamide agitated in the stirrer from sticking together or to inhibit stagnant stirring, and was also formed in a screw type with application of a vertical rotation axis (FIG. 1b). Accordingly, niacinamide inside a cylinder surrounding the blades of the stirrer is discharged and scattered upwards in parallel to the vertical rotation axis inside the stirrer rather than in left and right sides (FIG. 2). Niacinamide in powder form is not stagnant or stopped, but continues to circulate up and down while freely falling and collides with the ejected gold (Au) atoms.

The vacuum chamber is connected to a mass flow controller (MFC) and a rotary pump, in order to maintain a constant temperature by supplying a coolant to an outer wall of the stirrer while maintaining a predetermined vacuum degree.

### Example 1-2. Preparation of gold nanoparticles

Gold with a purity of 99.9% or more was used as a sputtering target, and was bound to a magnet cathode. After charging niacinamide into the stirrer and reaching the vacuum degree inside the chamber to 2.0 to 3.0 x 10⁻⁵ torr, argon gas was injected into the magnet cathode to generate plasma. Herein, the vacuum degree inside the chamber became to be rapidly changing to 1.0 to 2.0 × 10⁻² torr. By operating the MFC (Mass flow controller) and rotary pump, the coolant was supplied to the outer wall of the stirrer while conducting agitation simultaneously in a state of maintaining the vacuum degree of 1.0 to 2.0 x 10⁻² torr, followed by proceeding the work for at least 5 hours. At this time, the temperature inside the chamber was maintained at 60 to 70 °C, and the niacinamide inside the stirrer also became to be maintained at 60 to 70 °C.

By generating plasma on the surface of the gold target in a vacuum state, pure gold particles of several nanometers are freely ejected. The ejected gold particles are induced to bind to the surface of niacinamide. At this time, in order to prevent the gold particles bound to niacinamide from being recombined between gold particles and increasing a size of the particles, the stirrer was built in the vacuum chamber to make the niacinamide flow physically. The ejected gold particles are either weakly bound to niacinamide or unbound and agitated along with niacinamide in the form of particles, and the same process is repeated until the agitation is stopped and the vacuum is broken off. As a result, since niacinamide flowing up and down prevented recombination between the ejected gold particles, perfectly separated gold nanoparticles having a size of 1 to 5 nm were obtained (FIG. 3) .

In other words, instead of forming a thin film by utilizing vacuum deposition, the ejected gold atoms did not bind strongly to niacinamide before formation of a thin film, and recombination between gold atoms was prevented by secondary physical agitation, thereby obtaining nanometer-scale gold particles. Therefore, according to a process performed in a high vacuum state, it is possible to produce nanoparticles having the same purity as that of gold prepared as a target without the presence of moisture, harmful gas, foreign substances, and the like.

### Example 2. Comparison of Yield of Gold Nanoparticles

In order to compare the yield of gold nanoparticles according to a stirring direction of the carrier, i) the stirrer of the present invention in which the carrier is discharged upwardly and circulates up and down in parallel to a vertical rotation axis (Experimental Example 1), ii) a stirrer in which the carrier rotates about the vertical rotation axis (Comparative Example 1), and iii) a stirrer in which the carrier rotates about a horizontal rotation axis (Comparative Example 2), were fabricated, respectively. Then, niacinamide powder was charged into the stirrer, followed by preparing gold nanoparticles in the same manner as described in Example 1. The yield of gold nanoparticles bound to niacinamide was measured, and the average values thereof are shown in Table 1 below.

**[TABLE 1]**

| Division | Yield |
|---|---|
| Experimental Example 1 | 76.6% |
| Comparative Example 1 | 49.3% |
| Comparative Example 2 | 61.6% |

As a result, it was confirmed that the stirrer of Experimental Example 1 in which niacinamide is discharged upward and circulates up and down in parallel to the vertical rotation axis has the most remarkable yield of 76.6%, whereas the stirrer of Comparative Example 1 in which niacinamide rotates about the vertical rotation axis showed the lowest gold nanoparticle yield. The reason for the above results is considered because, as compared to the stirrer of Experimental Example 1 where most of input energy is used to vertically move niacinamide toward gold particles as the gold particles are incident in the vertical direction, the stirrer of Comparative Example 1 or Comparative Example 2 uses most of the input energy to rotate niacinamide horizontally or vertically to thus reduce collision efficiency. That is, in the production of gold nanoparticles through vacuum deposition according to the present invention, it could be understood that the stirring direction of niacinamide had significant effects on the yield, and the stirring method of the present invention, in which niacinamide is discharged upward in parallel to the vertical rotation axis and collides with the gold particles, exhibited the highest yield.

### Example 3. Comparison of Size and Purity of Gold Nanoparticles

Gold nanoparticles were prepared using glucose and hydroxyl ethyl cellulose (HEC) generally used as carriers on which nanoparticles are formed, and the yield and size of the particles were compared. Specifically, 120 g of 99.9% pure gold was placed on a magnet cathode, and niacinamide powder, glucose powder and a HEC chip were incorporated into a stirrer, followed by preparing gold nanoparticles bound to each carrier in the same manner as in Example 1. Thereafter, by heating the niacinamide powder to which gold nanoparticles were bound to sublimate niacinamide, only pure gold nanoparticles were obtained. Further, nanoparticles in which glucose and HEC are used as carriers were dissolved in glucose and HEC by adding water, thereby obtaining dispersed gold nanoparticles. The obtained gold nanoparticles were subjected to measurement of diameter and purity through TEM and component analysis, and the average value was calculated and shown in Table 2 below.

**[TABLE 2]**

| Division | Diameter of nanoparticle | Purity |
|---|---|---|
| Niacinamide | 2.9 nm | 99.9% |
| Glucose | 8.9 nm | 91.7% |
| HEC | 13.2 nm | 87.2% |

As a result, it was confirmed that, when niacinamide was used as a carrier, it has the same purity (99.9%) as the target and, whereas the purity was significantly reduced when glucose or HEC was used as a carrier. The above results are judged to be due to the difference in processes of separating the carrier from the gold nanoparticles (heating or dissolving in water), and it could be seen that high purity gold nanoparticles can be obtained when niacinamide is used according to the present invention. Further, the nanoparticles are significantly smaller in size when niacinamide is used, as compared to use of glucose or HEC, whereby the present invention can be utilized in the production of finer gold nanoparticles compared to the conventional manufacturing process. This would be interpreted as a result of combining gold particles with a ketone group included in the molecular structure of niacinamide.

From the above description, those skilled in the art to which the present invention pertains will understand that the present invention may be embodied in other specific forms without changing the technical spirit or essential characteristics thereof. In this regard, it should be understood that the embodiments described above are illustrative in all respects and not restrictive. It should be construed that, rather than the above detailed description, all changes or modifications derived from the meaning and scope of the claims described below and their equivalents are included in the scope of the present invention.

## Claims

1. A method for manufacturing gold nanoparticles, comprising:
(a) placing a gold (Au) target on a magnet cathode and injecting argon (Ar) gas to generate plasma;
(b) discharging powder of a compound having a non-shared electron pair upwardly in parallel to a vertical rotation axis inside a stirrer, followed by circulating and agitating the same up and down; and
(c) ejecting the gold particles and binding the same to the compound having the non-shared electron pair.

2. The method according to claim 1, wherein the compound having a non-shared electron pair is a compound containing a thiol group or ketone group.

3. The method according to claim 2, wherein the compound containing a thiol group or ketone group is niacinamide.

4. The method according to claim 1, wherein the step (b) is conducted at a temperature of 40 to 100 °C and with a vacuum degree of 1.0 to 2.0 x 10⁻² torr.

5. The method according to claim 1, wherein the gold nanoparticle has a diameter of 1 to 10 nm.

6. The method according to claim 3, further comprising (d) heating niacinamide.

7. Gold nanoparticles manufactured according to the method as set forth in claim 1.
